# EUROPEAN PATENT APPLICATION

(11) **EP 4 502 866 A1**
(43) Date of publication of application: **05.02.2025**
(21) Application number: 22935667.0
(22) Date of filing: 29.11.2022
(51) Int. Cl.: G06K 19/077, H01L 21/60

(54) **IC CHIP MOUNTING DEVICE AND IC CHIP MOUNTING METHOD**

(30) Priority: 31.03.2022 JP 2022058260
(71) Applicant: Sato Holdings Kabushiki Kaisha, Tokyo 108-0023 (JP)
(72) Inventor: MAEDA, Yoshimitsu, Tokyo 108-0023 (JP)
(74) Representative: Grünecker Patent- und Rechtsanwälte PartG mbB
(86) International application number: PCT/JP2022/043864
(87) International publication number: WO 2023/188538

(57) **Abstract**

An embodiment of the present invention is an IC chip mounting apparatus comprising: a conveyor configured to convey an antenna continuous body, the antenna continuous body having a base material and a plurality of inlay antennas continuously formed on the base material; an IC placement unit configured to place an IC chip on an adhesive, the adhesive being provided at a reference position of each of the antennas of the antenna continuous body; and a unit attachment configured to replaceably attach a light curing unit and a thermal curing unit, the light curing unit curing the adhesive by irradiating the adhesive with light, while pressing the IC chip placed on the adhesive toward an antenna side, the thermal curing unit curing the adhesive by heating the adhesive, while pressing the IC chip placed on the adhesive toward an antenna side.

## Description

### FIELD

The present invention relates to an IC chip mounting apparatus and an IC chip mounting method.

### BACKGROUND

With the spread of RFID tags, production of sheet-shaped inlays having an antenna and an IC chip electrically connected to the antenna is expanding. Manufacturing of an inlay involves, in an antenna formed on a base material, includes: providing an adhesive at a reference position, which is a reference for mounting an IC chip, of an antenna formed on a base material; placing an IC chip on the reference position; and then curing the adhesive to fix the IC chip.

It is described in Japanese Unexamined Patent Application Publication No. 2016-133982, for example, an IC chip bonding method that includes: a mounting process for mounting an IC chip on a base material on which an conductive adhesive is applied; pressing the base material and the IC chip, which has been mounted on the base material, by sandwiching them between an upper head and a lower head in upward and downward directions; and then heating the conductive adhesive that have been applied.

### BRIEF SUMMARY

### TECHNICAL PROBLEM

As described above, conventional IC chip mounting apparatuses have conducted thermal curing in mounting an IC chip on a base material (an antenna formed on a PET film, for example) on which an adhesive is applied. Incidentally, a RFID tag of a resource-saving type is prevalent. This RFID tag includes an antenna formed on a back face of a thermal base material having a thermosensitive layer and an IC chip mounted on the antenna. In such RFID tag, a thermal base material is applied for a base material of an inlay. Thus, a thermal base material is used as both an inlay and a base material of the RFID tag, and one face (namely, a thermosensitive layer) of the inlay is utilized as a print surface. However, there is a problem that the thermosensitive layer is color-developed when an adhesive is thermally cured after an IC chip is mounted. In light of this, a light curing method has been considered which cures an adhesive by irradiating with ultraviolet for example, without applying heat to prevent color from being developed. However, because a process for curing an adhesive and a process for mounting an IC chip are inseparable, it is required to separately provide an IC chip mounting apparatus adapted for thermal curing and an IC chip mounting apparatus adapted for light curing, thereby affecting productivity.

An object of one aspect of the present invention is to provide an IC chip mounting apparatus adapted for both thermal curing and light curing, while easily switching between thermal curing and light curing.

### SOLUTION TO PROBLEM

An embodiment of the present invention is an IC chip mounting apparatus comprising: a conveyor configured to convey an antenna continuous body, the antenna continuous body having a base material and a plurality of inlay antennas continuously formed on the base material;
an IC placement unit configured to place an IC chip on an adhesive, the adhesive being provided at a reference position of each of the antennas of the antenna continuous body; and
a unit attachment configured to replaceably attach a light curing unit and a thermal curing unit, the light curing unit curing the adhesive by irradiating the adhesive with light, while pressing the IC chip placed on the adhesive toward an antenna side, the thermal curing unit curing the adhesive by heating the adhesive, while pressing the IC chip placed on the adhesive toward an antenna side.

### ADVANTAGEOUS EFFECTS

An embodiment of the present invention enables easy switching between thermal curing and light curing with a single IC chip mounting apparatus, thereby enhancing productivity.

### BRIEF DESCRIPTION OF DRAWINGS

FIG. 1 shows a plane view of an antenna of an embodiment and partially enlarged views of the antenna before and after an IC chip is mounted.
FIG. 2 shows an antenna sheet and a roll of the antenna sheet.
FIG. 3 shows an area corresponding to an IC chip placement process of an IC chip mounting apparatus of an embodiment.
FIG. 4 shows a chip-containing tape and an enlarged sectional view thereof.
FIG. 5 is a side view of a rotary mounter of the IC chip mounting apparatus of the embodiment.
FIG. 6 schematically illustrates a relation between the rotary mounter and the antenna sheet.
FIG. 7 is a perspective view showing separation of the chip-containing tape by a separation roller.
FIG. 8 illustrates action of supplying an IC chip to a nozzle unit from the chip-containing tape.
FIG. 9 shows a conveying method of the antenna sheet in a curing device of an embodiment.
FIG. 10 shows a situation where a curing process is performed in the curing device of an embodiment.
FIG. 11 shows a status of the curing device of an embodiment to which an ultraviolet curing unit is attached.
FIG. 12 shows configurations of the ultraviolet curing unit and a thermal curing unit.
FIG. 13 shows a configuration of a press unit in the curing device of an embodiment.
FIG. 14 shows a side view and a bottom view of an upper unit attachment included in the curing device of an embodiment.
FIG. 15 is a functional block diagram of a control unit for controlling the curing device of an embodiment.

### DETAILED DESCRIPTION

Hereinafter, an IC chip mounting apparatus and an IC chip mounting method according to an embodiment will be described with reference to drawings.

An IC chip mounting apparatus 1 according to the embodiment is an apparatus for mounting an IC chip on a thin film antenna in manufacturing a contactless communication inlay, such as an RFID inlay.

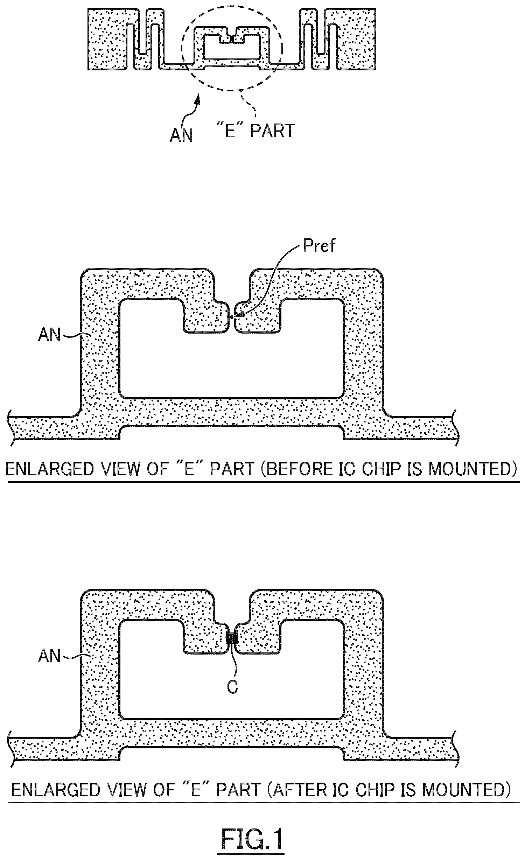

FIG. 1 shows an exemplary antenna AN having a predetermined antenna pattern, but there is no intention to limit the antenna pattern thereto. FIG. 1 also shows enlarged views of an "E" part before and after an IC chip "C" is mounted on the antenna AN. In this example, an IC chip "C" is mounted at a predetermined reference position Pref that is determined in advance based on the antenna pattern. The IC chip "C" has such a very small size as several hundreds of micrometers in length and width dimensions, and this very small IC chip "C" is required to be mounted exactly at the reference position Pref.

Mounting the IC chip "C" on the antenna AN involves an IC chip placement process and a curing process. In the IC chip placement process, an adhesive is applied to the reference position Pref of the antenna AN, and the IC chip "C" is placed on the adhesive. In the curing process, the adhesive is cured to strongly connect the antenna AN and the IC chip "C".

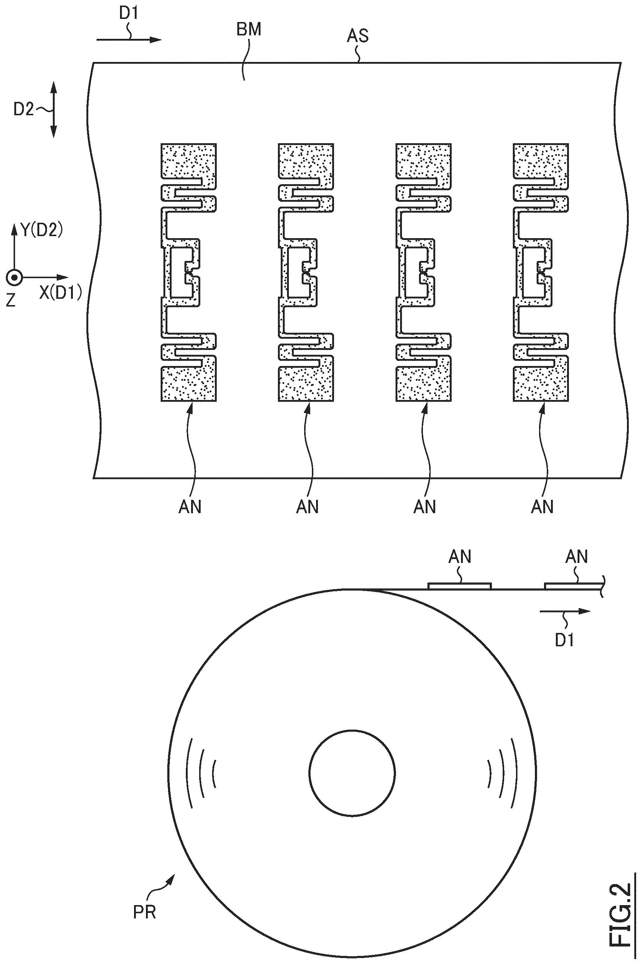

In the IC chip placement process (described later), a roll PR of a strip antenna sheet AS (an example of an antenna continuous body), as shown in FIG. 2, is set. The antenna sheet AS includes a plurality of antennas AN formed on a base material BM with constant pitches. The antenna sheet AS is continuously pulled out of the roll PR and is provided to a line of the IC chip placement process.

Examples of the material that can be used for the base material BM include, but not specifically limited to, paper base materials such as fine paper, coated paper, and art paper, synthetic resin films made of polyethylene terephthalate (PET), polyethylene (PE), polypropylene (PP), or polystyrene (PS), sheets made of a plurality of these synthetic resins, and composite sheets of a synthetic resin film and paper.

The antenna AN is formed, for example, by attaching a metal foil to a base material BM or by screen-printing or vapor-depositing a conductive material into a predetermined pattern on a base material BM.

In the following description, an XYZ coordinate system is defined as shown in FIG. 2. The following describes a front view as a YZ-plane view, a plane view as an XY-plane view, and a side view as an XZ-plane view in referring to the drawings of components set in each process.

The X-direction is a direction of conveying the antenna sheet AS, which is pulled out of the roll PR, in each process described below, and it is also called a "conveying direction D1" as appropriate. In addition, the Y-direction is a width direction of the antenna sheet AS and is also called a "width direction D2" as appropriate. The Z-direction is a direction orthogonal to the antenna sheet AS.

### (1) IC Chip Placement Process

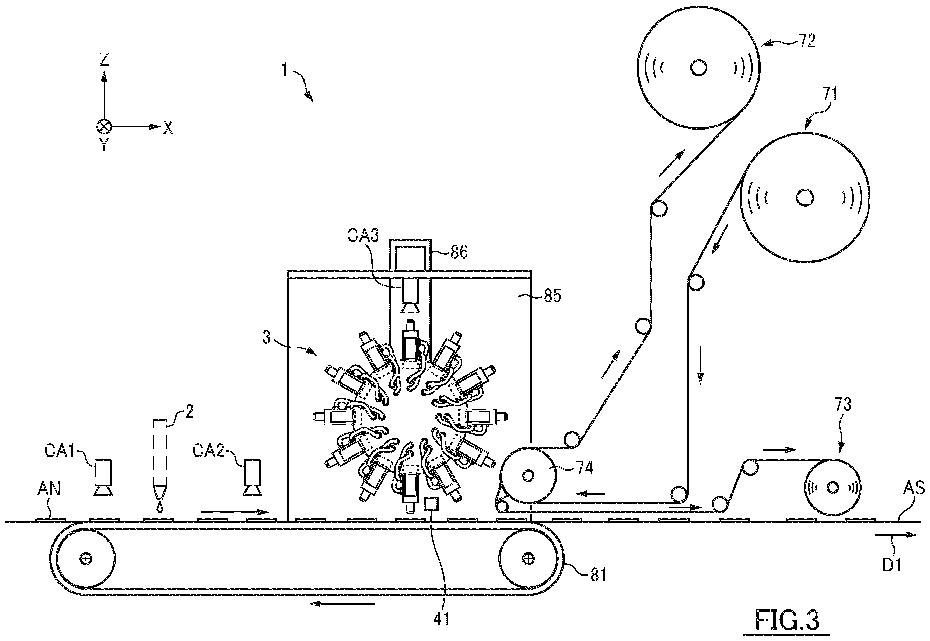

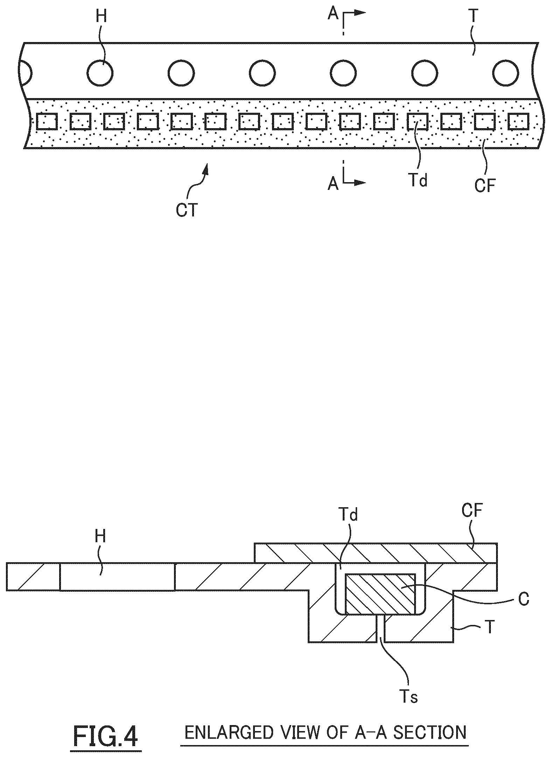

Hereinafter, the IC chip placement process will be described with reference to FIGS. 3 to 8. FIG. 3 shows an area corresponding to the IC chip placement process of the IC chip mounting apparatus 1 of this embodiment. FIG. 4 shows a plane view of a chip-containing tape CT and an enlarged view of an A-A section thereof.

In the IC chip placement process, the IC chip mounting apparatus 1 accurately places an extremely small IC chip at the reference position Pref (refer to FIG. 1) of each antenna AN on the antenna sheet AS.

As shown in FIG. 3, the IC chip mounting apparatus 1 includes a conveyor 81, a dispenser 2, a rotary mounter 3, an ultraviolet irradiator 41, image capture devices CA1 to CA3, a tape feeder 71, a tape body winding reel 72, a film winding reel 73, and a separation roller 74, in the IC chip placement process.

The conveyor 81 (an example of a conveyer) conveys the antenna sheet AS that is pulled out of the roll PR (refer to FIG. 2) to the downstream of the process at a predetermined conveying speed. An upper surface of the conveyor 81 corresponds to a conveying surface.

The dispenser 2 ejects a fixed amount of anisotropic conductive paste (ACP; hereinafter simply called "conductive paste") to the reference position Pref of each antenna AN that is conveyed. This conductive paste is an example of adhesive that is an ultraviolet light curable. The dispenser 2 is configured so that the ejection position can be adjusted in the width direction, in order to accurately determine the ejection position relative to the reference position Pref of each antenna AN.

The image capture device CA1 is provided upstream of the dispenser 2 and captures an image of a part in the vicinity of the reference position Pref of each antenna AN, in order to determine the position to be applied with the conductive paste. The image capture device CA2 is provided downstream of the dispenser 2 and captures an image of a part in the vicinity of the reference position Pref of each antenna AN, in order to inspect whether the conductive paste is applied to each antenna AN and to inspect whether the conductive paste is applied exactly to a region including the reference position Pref.

The rotary mounter 3 (an example of an IC placement unit) is a chip mounter that places an IC chip on the conductive paste that is applied to each antenna AN, and it rotates in a counterclockwise direction in FIG. 3. The rotary mounter 3 is mounted to a suspension plate 86, and the suspension plate 86 is fixed to a support stand 85. That is, the rotary mounter 3 is suspended from above by the support stand 85.

As described later, the rotary mounter 3 sucks an IC chip from the chip-containing tape and places (mounts) the sucked IC chip by releasing it to the reference position Pref of each antenna AN on the antenna sheet AS.

The tape feeder 71 is configured to be loaded with a wound chip-containing tape that contains IC chips and to cause the chip-containing tape to be pulled out sequentially at a speed synchronized with the rotary mounter 3, in the arrow directions in FIG. 3.

Herein, an example of the chip-containing tape will be described with reference to FIG. 4.

As shown in FIG. 4, the chip-containing tape CT includes a tape body "T" and a cover film CF. Recesses Td for containing IC chips "C" are formed at fixed intervals in the tape body "T". The cover film CF is attached to the tape body "T" so as to cover the recesses Td. The recesses Td are formed, for example, by embossing the tape body "T". The IC chip "C" is contained in each recess Td along the extending direction of the chip-containing tape CT. The chip-containing tape CT has fitting holes H that are formed at fixed intervals in the extending direction. These fitting holes H are provided in order to accurately perform positioning relative to a circumferential surface of the separation roller 74. The fitting holes H are fitted into protrusions 74p (described later), which are provided to the separation roller 74, while the chip-containing tape CT is conveyed by the separation roller 74.

As shown in FIG. 4, a suction hole Ts is formed between a bottom surface of the recess Td and a back surface (surface on a side opposite to the surface attached with the cover film CF) of the tape body "T". The suction hole Ts is provided so as to make the separation roller 74 suck an IC chip "C", in order to prevent the IC chip "C" from falling out of the recess Td when the cover film CF is peeled off.

With reference to FIG. 3 again, the chip-containing tape CT is fed from the tape feeder 71 via one or a plurality of auxiliary rollers, and the cover film CF is peeled off from the chip-containing tape CT to be separated from the tape body "T" at the separation roller 74. The IC chip "C" is exposed upon peeling off the cover film CF and is sequentially sucked by each nozzle that is provided to the rotary mounter 3.

After the chip-containing tape CT is separated into the tape body "T" and the cover film CF by the separation roller 74, the tape body "T" is wound by the tape body winding reel 72 via one or a plurality of auxiliary rollers, whereas the cover film CF is wound by the film winding reel 73 via one or a plurality of auxiliary rollers.

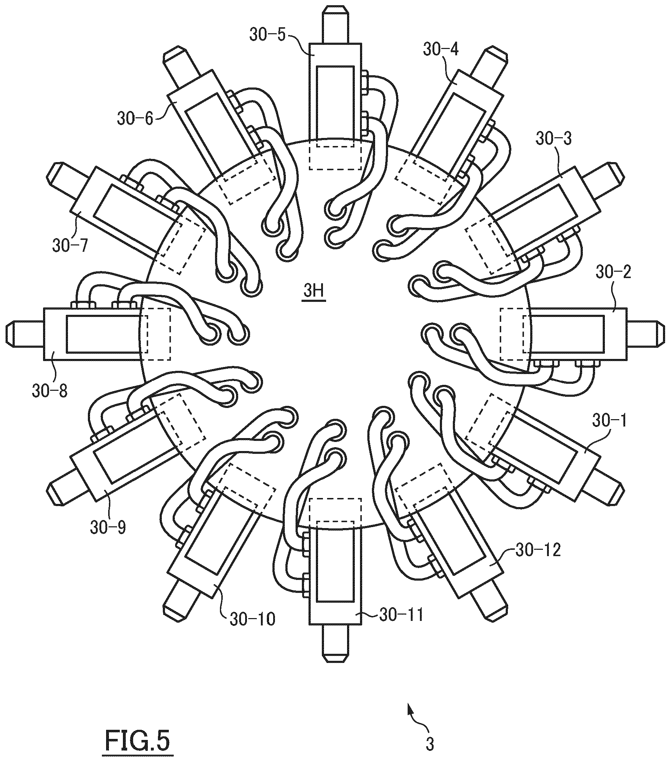

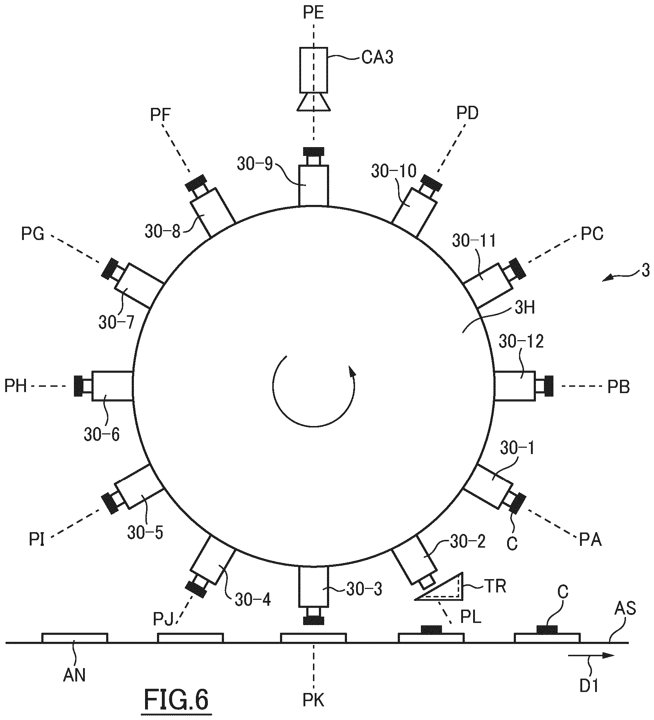

Next, the rotary mounter 3 will be described with reference to FIGS. 5 and 6.

FIG. 5 is a side view of the rotary mounter 3 of the IC chip mounting apparatus 1 of this embodiment. FIG. 6 schematically illustrates a relation between the rotary mounter 3 and the antenna sheet AS.

As shown in FIG. 5, a plurality of nozzle units (twelve units in the example of the drawing) 30-1 to 30-12 are arranged radially from a rotary head 3H in the rotary mounter 3. The following collectively describes the nozzle units 30-1 to 30-12 as "nozzle units 30" when referring to matters that are common therebetween.

Although not illustrated in detail, the rotary head 3H is connected to a rotary drive motor, a vacuum pump, and a blower. The rotary drive motor rotates the nozzle units 30-1 to 30-12 in a counterclockwise direction in FIG. 5. The vacuum pump causes the nozzle unit 30 to suck an IC chip. The blower causes the nozzle unit 30 to release the IC chip.

With reference to FIG. 6, the rotary head 3H is rotated in a counterclockwise direction by the rotary drive motor (not shown), and accordingly, the positions on the circumference of the rotary head 3H of the nozzle units 30 are switched one by one. In more detail, one nozzle unit 30 sequentially shifts twelve positions PA to PL from the position PA to the position PL on the circumference of the rotary head 3H in the counterclockwise direction in such a manner as to move on a circular track on a flat plane orthogonal to the conveying surface, in accordance with rotation of the rotary head 3H.

Herein, the position PA is a position where the nozzle unit 30 sucks a new IC chip "C" from the chip-containing tape CT. The position PE is a position where the image capture device CA3 images the IC chip "C" in the state of being sucked by the nozzle of the nozzle unit 30.

The position PK is a position where the sucked IC chip "C" is released on the conductive paste applied to the antenna AN of the antenna sheet AS that is conveyed. The moving direction of the top of the nozzle matches the conveying direction D1 of the antenna sheet AS at the position PK. The nozzle unit 30 discharges air from the nozzle to release the IC chip "C" at the position PK.

The nozzle unit 30 does not suck the IC chip "C" at the position PL, as it has released the IC chip "C" at the position PK. In order to remove dust that may adhere to the nozzle, air may be jetted out from the nozzle at the position PL. FIG. 6 shows an example of disposing a dust collection tray TR for collecting dust that may be detached from the nozzle, at the position PL.

In an example, the following action is repeated. In FIG. 6, the nozzle unit 30-1 at the position PA sucks a new IC chip "C" thereat and rotates in the counterclockwise direction while sucking the IC chip "C", and it then releases the IC chip "C" upon reaching the position PK and returns to the position PA to suck a new IC chip "C" again. Such an IC chip mounting method enables continuously placing the IC chip on each antenna AN without stopping conveyance of the antenna sheet AS, resulting in high productivity.

The angular velocity of the rotary head 3H and the conveying speed of the antenna sheet AS are set or controlled so that the nozzle unit 30, which sequentially reaches the position PK, will release the IC chip "C" to the reference position Pref of each antenna AN of the antenna sheet AS, which is conveyed from the upstream side. In order to accurately place the IC chip "C", it is preferable to provide a section where the speed of the top of the nozzle unit 30 is equal to the conveying speed of the antenna sheet AS, in proximity to the position PK.

Note that this embodiment shows an example of arranging twelve nozzle units 30 to the rotary head 3H, but the number of the nozzle units 30 is not limited thereto. The number of the nozzle units 30 that are arranged to the rotary head 3H can be set to any number.

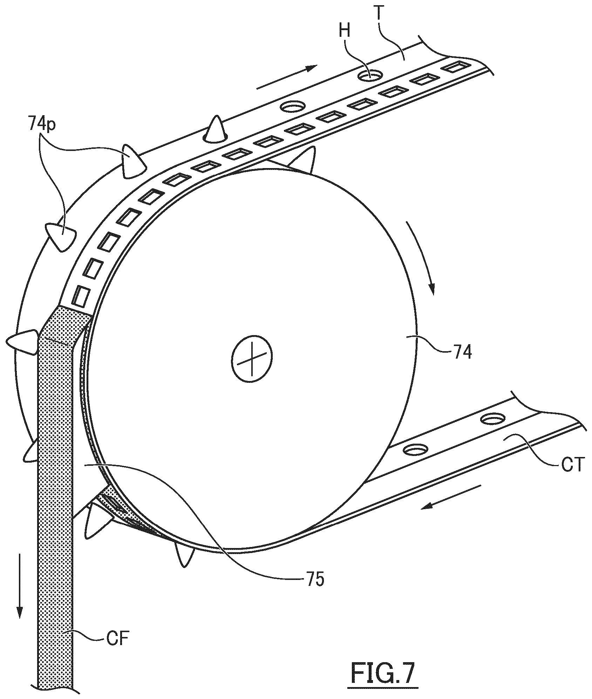

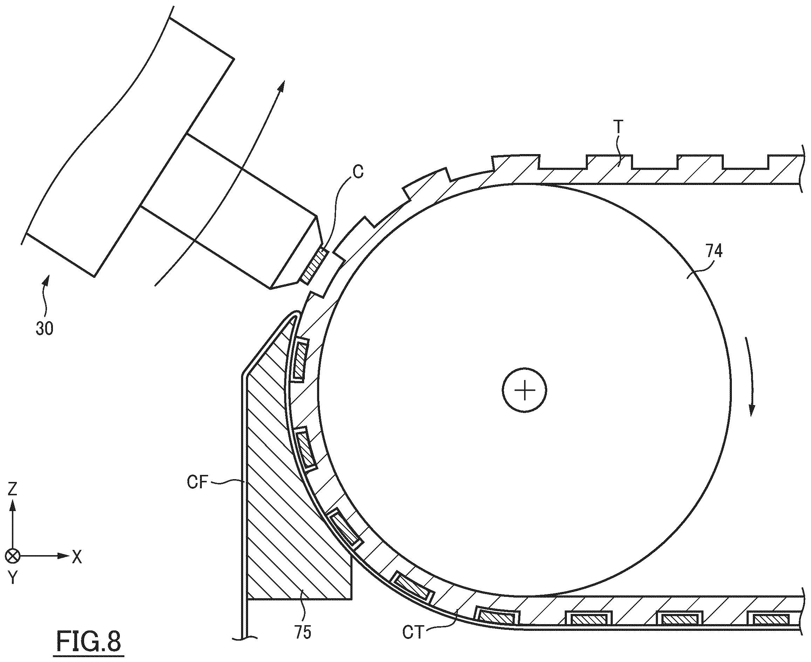

Next, action of the nozzle unit 30 sucking the IC chip "C" will be described with reference to FIGS. 7 and 8.

FIG. 7 is a perspective view showing separation of the chip-containing tape CT by the separation roller 74. FIG. 8 is a side view of the vicinity of the separation roller 74, illustrating action of supplying the IC chip "C" to the nozzle unit 30 from the chip-containing tape CT. In order to show the state of the chip-containing tape CT, only the chip-containing tape CT is illustrated in cross-section in FIG. 8.

As shown in FIG. 7, the chip-containing tape CT, which is supplied from the tape feeder 71, is conveyed while its position in the width direction is determined by inserting the protrusions 74p of the separation roller 74 into the fitting holes H of the chip-containing tape CT. At this time, the cover film CF is peeled off from the chip-containing tape CT by a split member 75 and is sent to the film winding reel 73. On the other hand, the tape body "T" of the chip-containing tape CT is sent to the tape body winding reel 72.

As shown in FIG. 8, the IC chip "C" that is exposed due to peeling off of the cover film CF is immediately sucked by the nozzle unit 30. The separation roller 74 is provided with a suction path (not shown) for sucking the IC chip "C" toward the rotation center of the separation roller 74, so that the IC chip "C" will not fall out during a short period from a time when the IC chip "C" is exposed until it is sucked by the nozzle unit 30. The IC chip "C" is sucked through this suction path and the suction hole Ts (refer to FIG. 4) provided to the tape body "T".

### (2) Curing Process

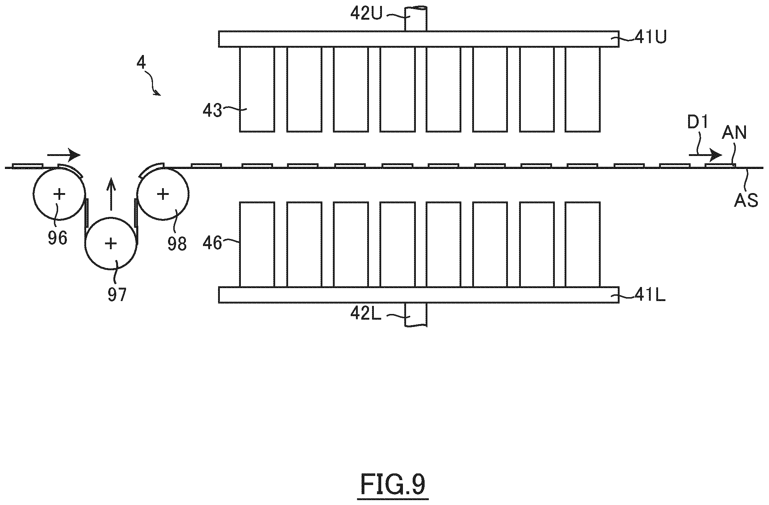

Next, the curing process will be described with reference to FIGS. 9 to 15.

The curing process involves curing the conductive paste, which is applied to each antenna and undergoes the IC chip placement process, whereby the physical connection between the antenna and the IC chip is strengthened, and the electrical conduction between the antenna and the IC chip is reliably made.

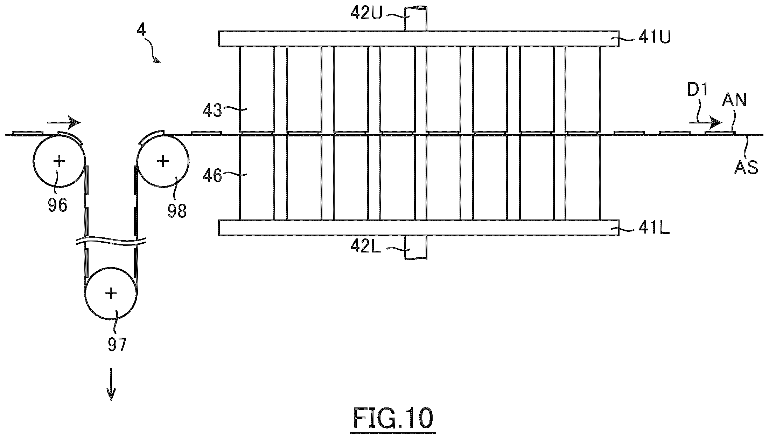

A curing process according to one embodiment is illustrated in FIG. 9 and FIG. 10, each of which shows a curing device 4 used in the curing process. The curing device 4 is configured to be able to simultaneously cure the conductive paste applied on the plurality of antennas AN on the antenna sheet AS. In FIG. 9 and FIG. 10, it is configured that the conductive paste on eight antennas AN are simultaneously cured, which is non-limiting. Any number of antennas AN on which the conductive paste can be cured simultaneously may be set.

The curing device 4 is configured to be able to install a plurality of curing units that simultaneously cure the conductive paste applied on the plurality of antennas AN. The plurality of curing units installed in the curing device 4 are either one of a plurality of ultraviolet curing units 43 (each being an example of a light curing unit) and a plurality of thermal curing units 45, both of which are replaceable in the curing device 4. In FIG. 9 and FIG. 10, the plurality of ultraviolet curing units 43 and a plurality of press units 46 that corresponds to the plurality of ultraviolet curing units 43 respectively are shown as an example.

Referring to FIG. 9, the curing device 4 is comprised of: an upper unit attachment 41U (an example of a unit attachment) for attaching the plurality of ultraviolet curing units 43; an elevating unit 42U; a lower unit attachment 41L for attaching the plurality of press units 46; and an elevating unit 42L. The elevating unit 42U moves the upper unit attachment 41U up and down with an actuator (not shown). The elevating unit 42L moves the lower unit attachment 41L up and down with an actuator (not shown).

The antenna sheet AS, which has been conveyed from the IC chip placement process, will be conveyed to the curing process via conveying rollers 96 to 98.

In a curing process according to one embodiment, a conveyed status and a suspended status are repeated. The conveyed status is a status in which the antenna sheet AS is conveyed. The suspended status is a status in which conveying the antenna sheet AS is suspended to cure the conductive paste. FIG. 9 shows the curing device 4 in the conveyed status, while FIG. 10 shows the curing device 4 in the suspended status.

In the conveyed status as shown in FIG. 9, in order for each curing unit not to prevent conveying of the antenna sheet AS, the upper unit attachment 41U is moved up and the lower unit attachment 41L is moved down so that each curing unit is retreated. In the suspended status as shown in FIG. 10, the upper unit attachment 41U is moved down and the lower unit attachment 41L is moved up so that each curing unit performs curing (ultraviolet curing or thermal curing), while pressing the antenna sheet AS from the front side and the back side.

Even in the suspended status (namely, a status in which curing is being performed by the curing device 4), the antenna sheet AS is conveyed from the IC chip placement process. Thus, while the curing process is performed, the conveying roller 97 moves down with its own weight to absorb the antenna sheet AS, which have been conveyed, between the conveying roller 96 and the conveying roller 98. Once the curing process has ended, the antenna sheet AS is rapidly conveyed to the downstream and then stopped so that each uncured antenna AN is located directly beneath the corresponding curing unit. When the antenna sheet AS is rapidly conveyed, the conveying roller 97 moves up with tension applied to the antenna sheet AS.

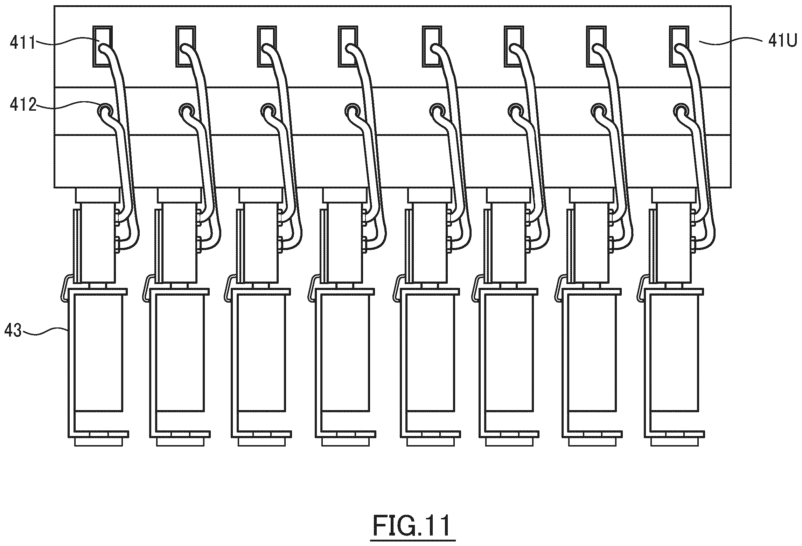

FIG. 11 shows the upper unit attachment 41U of one embodiment. In an example shown in FIG. 11, the plurality of ultraviolet curing units 43 is attached to the upper unit attachment 41U.

The upper unit attachment 41U is provided with connectors 411 and joints 412, each number of which corresponds to that of the ultraviolet curing units 43 that are simultaneously attachable. Through each connector 411, power is supplied to the corresponding ultraviolet curing unit 43. Through each joint 412, air is supplied to the corresponding ultraviolet curing unit 43. The ultraviolet curing unit 43 is provided with a connector that corresponds to and is fitted into each connector 411. The ultraviolet curing unit 43 is provided with a joint that corresponds to and is fitted each joint 412. The connector and the joint of the unit or the unit attachment may be male or female.

As described later, the ultraviolet curing unit 43 is provide with a magnet. The ultraviolet curing unit 43 can be attached to the upper unit attachment 41U with magnetic force with a single touch.

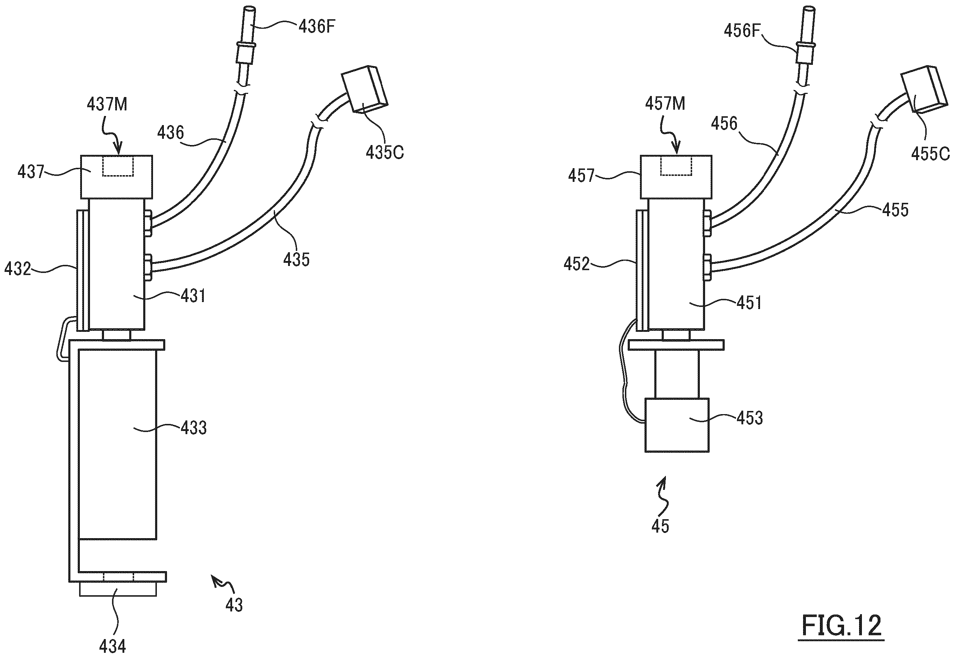

FIG. 12 shows an example of configuration of the ultraviolet curing unit 43 and the thermal curing unit 45.

As shown in FIG. 12, the ultraviolet curing unit 43 includes an air spring container 431, a circuit board 432, an ultraviolet irradiator 433, a glass plate 434, a cable 435, an air conduit 436, and an attachment 437.

The air spring container 431 is communicated with the air conduit 436. Air pressure is provided by the air spring container 431 when the ultraviolet curing unit 43 is caused to press the antenna AN. A joint 436F is attached to a tip of the air conduit 436. The joint 436F can be fitted into the joint 412 (see FIG. 11) of the upper unit attachment 41U.

The circuit board 432 operates with power supplied through the cable 435 and includes an infrared communication unit. The infrared communication unit contactlessly communicates with an outside control device to enable setting ultraviolet irradiation time by the ultraviolet irradiator 433 and monitoring of operation status of the ultraviolet irradiator 433, etc. The circuit board 432 is connected to the cable 435. A connector 435C is connected to a tip of the cable 435. The connector 435C can be fitted into the connector 411 (see FIG. 11) of the upper unit attachment 41U.

The ultraviolet irradiator 433 includes a light source (such as a LED light source) for irradiating ultraviolet to the conductive paste on the antenna AN. Power is supplied to the light source in the ultraviolet irradiator 433 from the circuit board 432. The ultraviolet irradiator 433 may be equipped with a collecting lens that collects ultraviolet irradiated from the light source.

The glass plate 434 transmits ultraviolet irradiated from the ultraviolet irradiator 433. The glass plate 434 has a pressing surface that presses an IC chip on the antenna AN as the ultraviolet curing unit 43 moves down.

The attachment 437 is a portion that is attached to the upper unit attachment 41U. In one embodiment, the attachment 437 includes a magnet 437M and is attached to the upper unit attachment 41U with magnetic force.

The ultraviolet curing unit 43 irradiates ultraviolet from the ultraviolet irradiator 433 to the conductive paste on the antenna AN, while pressing the IC chip, which is located on the conductive paste, toward the antenna side. Thereby, the conductive paste is cured and connection between the antenna and the IC chip is strengthened.

As shown in FIG. 12, the thermal curing unit 45 includes an air spring container 451, a circuit board 452, a heating unit 453, a cable 435, an air conduit 456, and an attachment 457.

The air spring container 451 is communicated with the air conduit 456. Air pressure is provided by the air spring container 451 when the thermal curing unit 45 is caused to press the antenna AN. A joint 456F is attached to a tip of the air conduit 456. The joint 456F is identical to the joint 436F of the ultraviolet curing unit 43 and can be fitted into the joint 412 (see FIG. 11) of the upper unit attachment 41U.

The circuit board 452 operates with power supplied through the cable 455 and includes an infrared communication unit. The infrared communication unit contactlessly communicates with an outside control device to enable setting temperature of the heating unit 453 and monitoring of operation status of the heating unit 453, etc. The circuit board 452 is connected to the cable 455. A connector 455C is connected to a tip of the cable 455. The connector 455C is identical to the connector 435C of the ultraviolet curing unit 43 and can be fitted into the connector 411 (see FIG. 11) of the upper unit attachment 41U.

The heating unit 453 includes a heater for heating the conductive paste on the antenna AN. Power is supplied to the heater in the heating unit 453 from the circuit board 452. The heating unit 453 presses the antenna AN as the thermal curing unit 45 moves down.

The attachment 457 is a portion that is attached to the upper unit attachment 41U and identical to the attachment 437 of the ultraviolet curing unit 43. In one embodiment, the attachment 457 includes a magnet 457M and is attached to the upper unit attachment 41U with magnetic force.

The thermal curing unit 45 heats the conductive paste on the antenna AN by the heating unit 453, while pressing the IC chip, which is located on the conductive paste, toward the antenna side. Thereby, the conductive paste is cured and connection between the antenna and the IC chip is strengthened.

As described above, the connector 435C of the ultraviolet curing unit 43 is identical to the connector 455C of the thermal curing unit 45. Each connector may include a power supply terminal and a ground terminal adapted for a common power supply. Electrical specification relating to the connector of the ultraviolet curing unit 43 is identical to that of the thermal curing unit 45. The joint 436F of the ultraviolet curing unit 43 is identical to the joint 456F of the thermal curing unit 45. Flow rate and pressure of air supplied from the upper unit attachment 41U may be commonized for the ultraviolet curing unit 43 and the thermal curing unit 45.

The attachment 437 of the ultraviolet curing unit 43 and the attachment 457 of the thermal curing unit 45 have an identical shape.

As described, the ultraviolet curing unit 43 and the thermal curing unit 45 are compatible electrically and mechanically to the upper unit attachment 41U.

The press unit 46 is attached to the lower unit attachment 41L. When the ultraviolet curing unit 43 or the thermal curing unit 45 is attached to the upper unit attachment 41U, the press unit 46 pinches the antenna sheet AS with the curing unit to press the IC chip "C" located on the antenna AS.

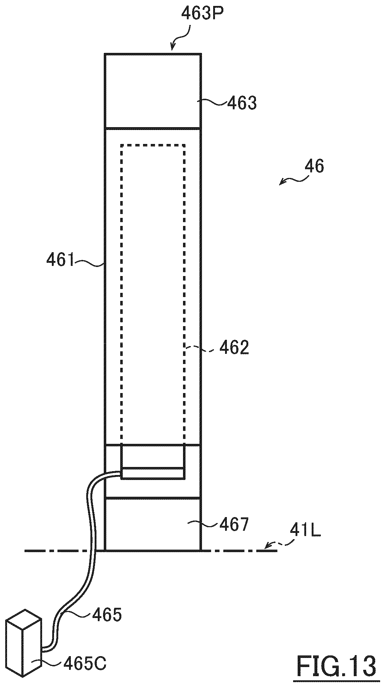

FIG. 13 shows an example of configuration of the press units 46. As shown in FIG. 13, the press units 46 includes a main body 461, a circuit board 462, a heating unit 463 a cable 465, and an attachment 467.

The main body 461 supports the heating unit 463 on the upper side and supports the attachment 467 on the lower side. The main body 461 includes the circuit board 462.

The circuit board 462 operates with power supplied through the cable 465 and includes an infrared communication unit. The infrared communication unit contactlessly communicates with an outside control device to enable setting temperature of the heating unit 463 and monitoring of operation status of the heating unit 463, etc. The circuit board 462 is connected to the cable 465. A connector 465C is connected to a tip of the cable 465. The connector 465C can be fitted into the connector (not shown) of the lower unit attachment 41L.

The heating unit 463 has a pressing surface 463p and a built-in heater. When the thermal curing unit 45 is attached to the upper unit attachment 41U, the heater heats the conductive paste on the antenna AN while pressing the conductive paste from the lower side. Power is supplied to the heater in the heating unit 463 from the circuit board 462. When the ultraviolet curing unit 43 is attached to the upper unit attachment 41U, the heating unit 463 presses the conductive paste on the antenna AN from the lower side, while not heating the conductive paste.

The attachment 467 is a portion that is attached to the lower unit attachment 41L. The press units 46 does not need to be replaced when any one of the ultraviolet curing unit 43 and the thermal curing unit 45 is attached to the upper unit attachment 41U. Any method may be applied for attaching the attachment 467 to the lower unit attachment 41L. Magnetic force or thread fastening may be applied in a similar fashion to the ultraviolet curing unit 43 and the thermal curing unit 45.

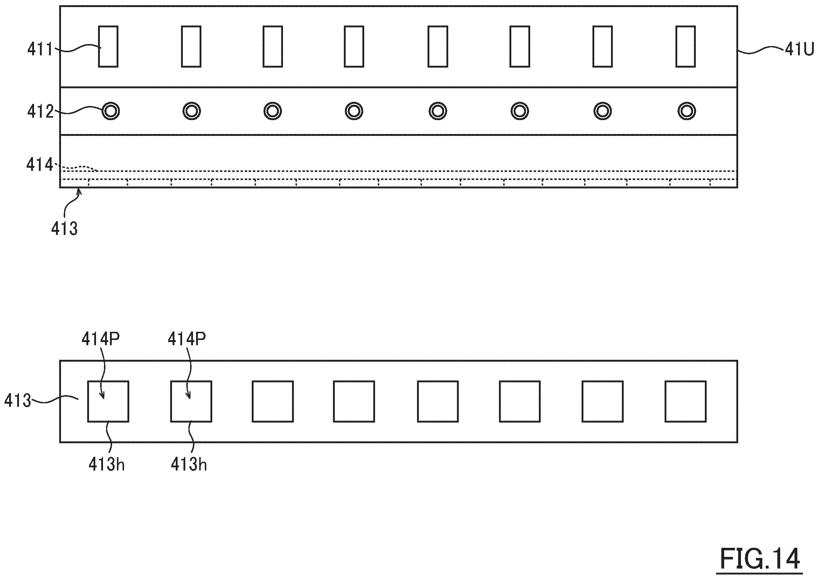

A structure of a portion of the upper unit attachment 41U to which each curing unit is attached will be described with reference to FIG. 14. FIG. 14 shows a side view and a bottom view of the upper unit attachment 41U.

As shown in FIG. 14, an opening-formed plate 413 is detachably attached to an exposed portion of the bottom part of the upper unit attachment 41U. For example, the opening-formed plate 413 is fastened by threads to a main body of the upper unit attachment 41U.

The opening-formed plate 413 has a plurality of openings 413h. The openings 413h are formed at fixed intervals along the conveying direction of the antenna sheet AS, and receives the attachments 437 or the attachments 457 of the plurality of curing units. As a size of the opening is slightly larger than each size of the attachments 437, 457, each curing unit is positioned when the attachments 437 or the attachments 457 are attached to the upper unit attachment 41U.

A distance between the adjoining openings 413h of the opening-formed plate 413 is set to be equal to a distance between the adjoining IC chips "C" located on the antenna sheet AS. Thus, in order to adapt to a variety of antenna sheets that may be conveyed in the IC chip mounting apparatus 1 (that is, sheets having different intervals of IC chips), a plurality of opening-formed plates with different intervals of openings may be prepared, and an opening-formed plate may be attached in response to a particular antenna sheet that is conveyed. Any method may be applied for attaching and detaching the opening-formed plate 413 to the main body of the upper unit attachment 41U. For example, thread fastening may be applied.

The upper unit attachment 41 has a holder 414 internally, which is located above the opening-formed plate 413. The holder 414 holds the attachments 457 or the attachments 457 of curing units while positioning the attachments. As shown in FIG. 14, viewed from the bottom, a holding surface 414P of the holder 414 is exposed from the openings 413h of the opening-formed plate 413. In one embodiment, the holding surface 414P is made of material having ferromagnetic property. Once the attachment of each curing unit is inserted in the opening 413h, the holding surface 414P holds the ultraviolet curing unit 43 or the thermal curing unit 45, with magnetic force that is caused with a magnet of the attachment.

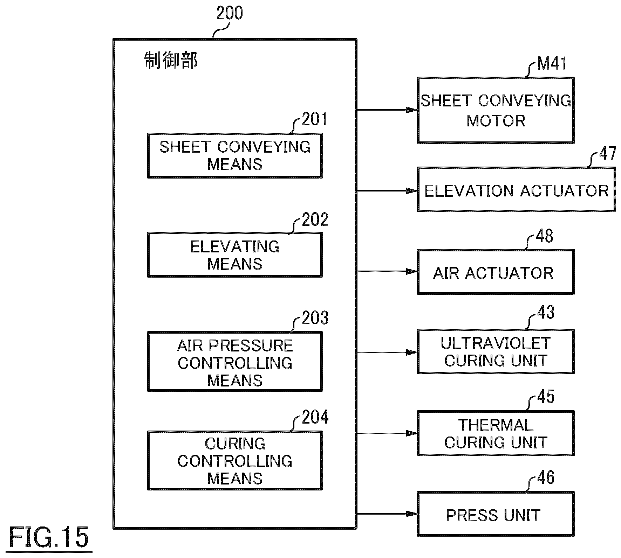

Next, control performed by a control unit 200 that controls the curing device 4 will be described with reference to FIG. 15. FIG. 15 shows a functional block diagram of the control unit 200.

The control unit 200 is mounted on a circuit board (not shown) of the curing device 4 and is electrically connected to a sheet conveying motor M41, an elevation actuator 47, an air actuator 48, the ultraviolet curing unit 43, the thermal curing unit 45, and the press units 46.

The control unit 200 includes a microcomputer, memories (random access memory (RAM) and read only memory (ROM)), a storage, and drive circuits. The microcomputer reads and executes a program recorded in the memory, and it implements each function of a sheet conveying means 201, an elevating means 202, an air pressure controlling means 203, and a curing controlling means 204.

The sheet conveying means 201 sends a control signal to a drive circuit of the sheet conveying motor M41 to control whether to further convey the antenna sheet AS, which has been conveyed from the IC chip placement process, to the post-process, or to suspend conveying the antenna sheet AS.

The elevating means 202 controls the elevating unit 42U and the elevating unit 42L to move the upper unit attachment 41U and the upper unit attachment 41U up or down.

Timing control is applied to the sheet conveying means 201 and the elevating means 202 so that the conveyed status and the suspended status are repeated. The conveyed status is a status in which the antenna sheet AS is conveyed, while the suspended status is a status in which conveying the antenna sheet AS is suspended to cure the conductive paste.

The air pressure controlling means 203 controls the air actuator 48 and control valves (not shown) so that air of preset pressure is supplied from an air tank (not shown) to the curing units attached to the upper unit attachment 41U.

The curing controlling means 204 performs infrared communication with the circuit board 432 of the ultraviolet curing unit 43, the circuit board 452 of the thermal curing unit 45, and the circuit board 462 of the press units 46 to set parameters for ultraviolet irradiation time and temperature in heating, etc. The curing controlling means 204 obtains data indicating operation status from each curing unit and each press unit, and displays the data on the screen.

As explained above, a belt-shaped antenna sheet is put on a production line. The antenna sheet has a base material on which a plurality of antennas is formed with fixed intervals. An IC chip is mounted on each antenna through the IC chip placement process and the curing process. The IC chip placement apparatus of the present embodiment, in the IC chip placement process, applies adhesive (namely, a conductive paste) at a reference position of an antenna, places an IC chip on the conductive paste, and cures the conductive paste in the curing process. Thereby, physical connection between the antenna and the IC chip is strengthened.

In the curing process particularly, electrical specification and mechanical specification relating to attachment and air supply are commonized. As switching between thermal curing and light curing becomes easy, the apparatus can be used for both thermal curing and light curing.

The IC chip mounting method according to one embodiment includes the following steps:
(a) conveying an antenna sheet AS, the antenna sheet AS having a base material BM and a plurality of antennas AN continuously formed on the base material BM;
(b) placing an IC chip "C" on a conductive paste, the conductive paste being provided at a reference position of each of the antennas AN of the antenna sheet AS; and
(c) attaching selectively a ultraviolet curing unit 43 or a thermal curing unit 45 to an upper unit attachment 41U, the ultraviolet curing unit 43 curing the conductive paste by irradiating the conductive paste with ultraviolet, while pressing the IC chip "C" placed on the conductive paste toward an antenna side, the thermal curing unit 45 curing the conductive paste by heating the conductive paste, while pressing the IC chip "C" placed on the conductive paste toward an antenna side.

Although the embodiments of the IC chip mounting apparatus and the IC chip mounting method according to the present invention have been described above, the present invention is not limited to the above-described embodiments. The above-described embodiments can be variously improved or modified within a range that does not depart from the essence of the present invention.

For example, each curing unit is attached to the attachment by use of magnetic force in the forementioned embodiment; however, the present invention is not limited to this attaching method example. The attachment of each curing unit and the holder of the unit attachment may be threaded and fixed each other.

Adhesives are cured with ultraviolet in the forementioned embodiment; however, the present invention is not limited to this example. Adhesives may be cured with light except ultraviolet, such as visible rays.

The present invention is related to Japanese Patent Application No. 2022-058260 filed with the Japan Patent Office on March 31, 2022, the entire contents of which are incorporated into this specification by reference.

## Claims

1. An IC chip mounting apparatus comprising:
a conveyor configured to convey an antenna continuous body, the antenna continuous body having a base material and a plurality of inlay antennas continuously formed on the base material;
an IC placement unit configured to place an IC chip on an adhesive, the adhesive being provided at a reference position of each of the antennas of the antenna continuous body; and
a unit attachment configured to replaceably attach a light curing unit and a thermal curing unit, the light curing unit curing the adhesive by irradiating the adhesive with light, while pressing the IC chip placed on the adhesive toward an antenna side, the thermal curing unit curing the adhesive by heating the adhesive, while pressing the IC chip placed on the adhesive toward an antenna side.

2. The IC chip mounting apparatus according to claim 1, wherein
each of the light curing unit and the thermal curing unit comprises an attachment of an identical shape at the opposite side of a pressing surface for pressing the IC chip toward the antenna side, and
the unit attachment comprises a holder for holding the attachment of each of the light curing unit and the thermal curing unit, while positioning the attachment.

3. The IC chip mounting apparatus according to claim 2, wherein
the attachment of each of the light curing unit and the thermal curing unit is provided with a magnet, and
the holder has a holding surface formed with a material of ferromagnetic property to hold either the light curing unit or the thermal curing unit.

4. The IC chip mounting apparatus according to claim 2 or 3, wherein
the unit attachment is configured to attach, along a conveying direction of the antenna continuous body, a plurality of the light curing units or a plurality of the thermal curing units at fixed intervals, and
the holder comprises an opening-formed plate with a plurality of openings formed at fixed intervals along the conveying direction of the antenna continuous body, each of the plurality of openings receiving and holding the attachment of each of the plurality of the light curing units or each of the plurality of the thermal curing unit.

5. The IC chip mounting apparatus according to claim 4, wherein the opening-formed plate is detachably attached.

6. The IC chip mounting apparatus according to any one of claims 1 to 5, wherein the light curing unit comprises a pressing surface made of glass, the pressing surface pressing the IC chip placed on the adhesive and transmitting light.

7. An IC chip mounting method comprising:
conveying an antenna continuous body, the antenna continuous body having a base material and a plurality of inlay antennas continuously formed on the base material;
placing an IC chip on an adhesive, the adhesive being provided at a reference position of each of the antennas of the antenna continuous body; and
attaching selectively a light curing unit or a thermal curing unit to a unit attachment device, the light curing unit curing the adhesive by irradiating the adhesive with light, while pressing the IC chip placed on the adhesive toward an antenna side, the thermal curing unit curing the adhesive by heating the adhesive, while pressing the IC chip placed on the adhesive toward an antenna side.
